# EUROPEAN PATENT SPECIFICATION

(11) **EP 1 734 803 B1**
(45) Date of publication and mention of the grant of the patent: **16.07.2008**
(21) Application number: 06076132.7
(22) Date of filing: 31.05.2006
(51) Int. Cl.: H05K 13/08

(54) **Method of adjusting at least one optional setting of a process characteristic of a component placement device, as well as such a component placement device and an electronic key**
Verfahren zur Einschaltung wenigstens eines fakultativen Einstellwertes in einem Bestückautomat, ein Bestückautomat und ein elektronischer Schlüssel
Méthode pour la sélection d'au moins une valeur de préférence dans un dispositif de montage de composants, le dispositif de montage et clé électronique

(30) Priority: 14.06.2005 NL 1029247
(43) Date of publication of application: 20.12.2006
(73) Proprietor: Assembléon B.V., 5503 LA Veldhoven (NL)
(72) Inventor: Nies, Alexander A. F., 5663 HP Geldorp (NL); Wilders, Richard A., 5503 PB Veldhoven (NL); Wendrich, Albertus R., 5671 HE Nuenen (NL)
(74) Representative: Veldman-Dijkers, Cornelia G. C.

(56) References cited:
- EP-A- 0 312 116
- EP-A- 0 948 250
- EP-A- 1 239 718
- US-A1- 2005 065 620

## Description

The invention relates to a method of adjusting at least one optional setting of a process characteristic of a component placement device provided with at least one component pickup and placement unit.

The invention also relates to a component placement device suitable for carrying out such a method.

The invention further relates to an electronic key suitable for use with such a method or with such a component placement device.

With such a method as well as component placement device as known from International patent application WO 97/22238, a component is picked up from a pickup position of a component feeder by a component pickup and placement unit, after which the picked-up component is moved to a component placement position on a substrate, such as a printed circuit board.

Depending on the type of component, the type of substrate, the customer's requirements, etc., a certain degree of precision is to be observed in positioning the component on the substrate. In addition, the component must be positioned on the substrate relatively quickly, for example in order to optimise the handling capacity, i.e. the number of components to be placed by the component placement device per unit time, and consequently the costs per component to be placed. To that end a user can adjust optional settings of the component placement devices. An optional setting of a process characteristic is, for example, the maximum rate of picking up components, the precision with which the component is to be positioned on the substrate, the maximum allowable acceleration forces on a component, etc.

In practice it has become apparent that the maximum handling capacity of the component placement device cannot be fully utilised during some periods, for example, and that during other periods the maximum handling capacity is insufficient for the number of components that a user wishes to be placed on substrates.

The purchase of additional component placement devices in order to have a higher maximum handling capacity available leads to relatively high investments, whilst a relatively large amount of available handling capacity will remain unused during relatively quiet periods in that case.

The object of the invention is to provide a method which enables a more efficient use of a component placement device.

This object is accomplished with the method according to the invention in that the component placement device has at least one standard setting, whilst the optional setting can be activated by means of an electronic key to be supplied to the component placement device, wherein said optional setting is temporarily activated by feeding the electronic key to the component placement device, whilst the standard setting is reactivated at least after the expiry of a predetermined period of operation of the electronic key.

When the component placement device is operated with the standard setting of a process characteristic, a predetermined, known result will be obtained. When a different result is to be achieved temporarily, however, an electronic key is supplied to the component placement device, as a result of which the component placement device will operate with the optional setting of the process characteristic in question for a predetermined period of operation.

After the expiry of the period of operation, the component placement device will revert to the standard setting of the process characteristic.

This enables the user to adapt the available component placement device temporarily according to his wishes by purchasing the electronic key and supplying it to the device. For example, a user will purchase the component placement device with one or more standard settings and one or more optional settings at a relatively low price. The optional settings, however, cannot be activated by the user right away. An optional setting can only be temporarily activated for the duration of the predetermined period of operation by purchasing the electronic key associated with the optional setting in question. This makes it possible, for example, to realise a higher handling capacity temporarily.

One embodiment of the method according to the invention is characterised in that a process characteristic comprises a number of optional settings, which can each be activated by means of an electronic key associated with a respective setting.

In this way it is possible to adjust the process characteristic in a number of ways in dependence on a setting that is required at a specific point in time. For example, if the process characteristic concerns the handling capacity, the handling capacity may for example be increased by 10%, 20%, 30% etc, depending on the selected setting.

Yet another embodiment of the method according to the invention is characterised in that the setting can be activated by means of a number of different electronic keys, each of which keys have a different period of operation.

In this way the period of operation of the optional setting in question can be selected as desired. Preferably, it will be cheaper in this connection to activate the setting for an uninterrupted, relatively long period of operation than to activate the setting for a comparable period of operation, using different electronic keys.

Yet another embodiment of the method according to the invention is characterised in that the standard setting is reactivated if the electronic key is removed at a point in time prior to the expiry of the period of operation, in which case the electronic key can be activated anew for the remaining period of operation at a later point in time.

In this way it is possible to reactivate the desired optional setting for the remaining period of operation at a later point in time, when the optional setting is required again.

Yet another embodiment of the method according to the invention is characterised in that the process characteristic comprises the handling capacity of the number of components to be placed by the component placement device per unit time.

The handling capacity can be temporarily increased and/or decreased, according to which is desired, by means of the electronic key. Thus it is possible to keep the initial costs of the component placement device relatively low, whilst the desired handling capacity can nevertheless be realised by purchasing the required electronic keys.

Another embodiment of the method according to the invention is characterised in that the handling capacity is temporarily increased by means of the electronic key.

The standard setting of the component placement device is such that the handling capacity realised with said setting is lower than the handling capacity realised with the optional setting.

Yet another embodiment of the method according to the invention is characterised in that the velocity at which a component is moved from a component pickup position to a component placement position is temporarily adapted by means of the electronic key.

By increasing the rate at which components are placed at a component placement position on a substrate, for example, a higher frequency of placing the component type in question can be realised. This will inter alia result in an increased handling capacity of the component placement device.

Yet another embodiment of the method according to the invention is characterised in that the velocity at which the component pickup and placement unit is moved from a component placement position to a component pickup position is temporarily adapted by means of the electronic key.

Increasing the velocity at which the component pickup and placement unit is moved to the component pickup position, for example, makes it possible to increase the handling capacity in a simple manner.

Yet another embodiment of the method according to the invention is characterised in that the component placement device includes a plurality of component pickup positions, wherein the number of component pickup positions that are accessible to the component pickup and placement unit is temporarily adapted by means of the electronic key.

In this way it is possible to decrease or increase, according to which is desired, the number of different components being presented via the various components pickup positions. In the case of a larger number of accessible component pickup positions, a wider range of different types of components can be placed on a substrate, so that the component placement device can be used for a wider range of substrates. This greater usability can only be realised, however, by supplying the electronic key to the component placement device.

Yet another embodiment of the method according to the invention is characterised in that the component placement device comprises a substrate supplying and discharging device, by means of which a substrate is moved to and from a position located near the component pickup and placement unit, wherein the transport velocity at which the substrate is moved is temporarily adapted by means of the electronic key.

The handling capacity can be influenced also by adapting the transport velocity.

The invention also relates to a component placement device suitable for carrying out the method according to the invention, which component placement device comprises at least one component pickup and placement unit as well as means for adjusting at least one optional setting of a process characteristic of the component placement device, characterised in that the component placement device has at least one standard setting, means for supplying at least one electronic key to the component placement device, means for activating said optional setting temporarily on the basis of the electronic key, as well as means for activating the standard setting at least after the expiry of a predetermined period of operation of the electronic key.

Said optional setting having a temporary period of operation makes it possible to have a component placement device operate in a manner that is desired at that moment during the period of operation of the electronic key, making it possible, for example, to realise a higher handling capacity.

The invention also relates to an electronic key, which is characterised in that the electronic key comprises a bar code, a numerical code, a magnetic code, an optical code, an RF code, a punch code, a chemical or a biological code.

A card provided with the electronic key, for example, can be read by a reading device connected to the component placement device, after which the electronic key can be supplied to the component placement device. It is also possible to supply the electronic key to the component placement device via an electronic network.

The invention will be explained in more detail with reference to the drawings, in which:
Figure 1 is a perspective view of a component placement device according to the invention; and
Figure 2 is a schematic, perspective view of a part of the component placement device that is shown in figure 1.

Like parts are indicated by the same numerals in the figures.

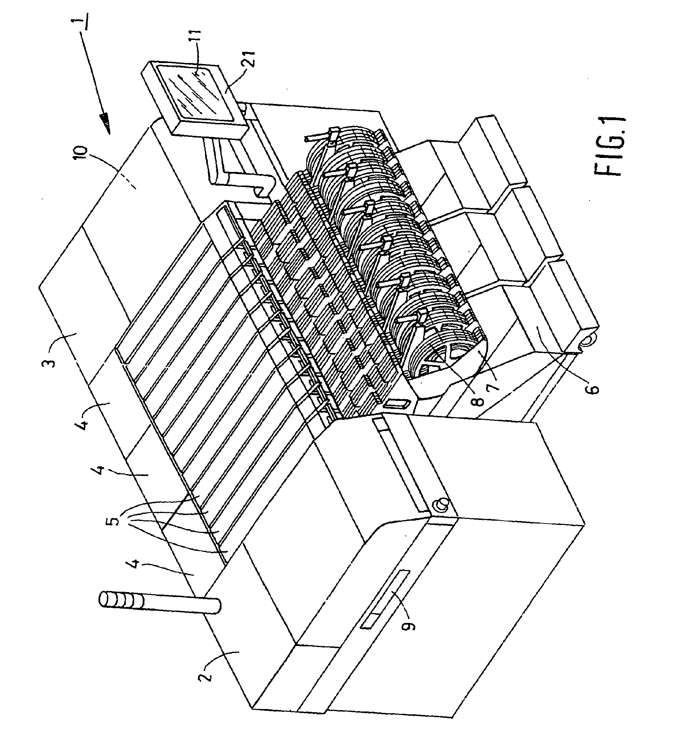

Figure 1 shows a component placement device 1 according to the invention, comprising a substrate supplying device 2, a substrate discharging device 3 and three modules 4 each consisting of four component pickup and placement units 5. The component placement device 1 furthermore comprises three trolleys 6, which are each provided with four reel holders 7, each of which wheel holders 7 accommodates six reels 8. A tape carrying components is wound on each reel 8.

The substrate supplying device 2 is provided with a substrate inlet opening 9, via which substrates 17 can be supplied to the component placement device 1. The substrate discharging device 3 is provided with a substrate outlet opening 10, via which the substrates 17 provided with components 29 can be discharged from the component placement device 1.

The component placement device 1 furthermore comprises a control unit 11.

The number of modules 4 and the corresponding number of trolleys 6 can be determined by a user according to his requirements upon purchase of the component placement device 1.

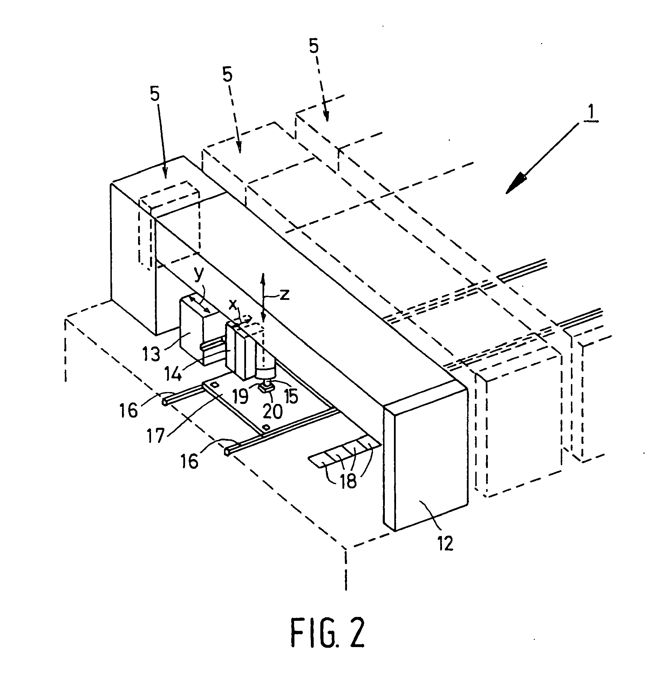

Figure 2 is a perspective view of a part of the component placement device 1 that is shown in figure 1, in which the structure of an individual component pickup and placement unit 5 is clearly shown.

The component pickup and placement unit 5 comprises an elongated, U-shaped frame 12, a first slide 13, which is movable in the directions indicated by the double arrow Y with respect to the frame 12, and a second slide 14, which is movable in the directions indicated by the double arrow X with respect to the slide 13, as well as a vacuum tube 15, which is movable in the directions indicated by the double arrow Z with respect to the second slide 14.

The component placement device 1 furthermore comprises two parallel rails 16, which support a substrate 17 to be provided with components 19. The substrate 17 can be moved stepwise at a specified carrying velocity over the rails 16 from the substrate inlet opening 9 to the substrate outlet opening 10.

Each component pickup and placement unit 5 includes a number of component pickup positions 18, which number corresponds to the number of reels 8 in the reel holder 7 that are associated with the component pickup and placement unit 5.

The component placement device is controlled in such a manner from the control unit 11 that a desired component 19 is picked up from a component pickup position 18 by each component pickup and placement unit 5, after which the component 19 picked up by means of the vacuum tube 15 is moved to a component placement position 20 on the substrate 17 and placed on the substrate 17 at that position. The component placement device 1 as described so far and the operation thereof are known per se and will not be explained in more detail herein, therefore.

As already indicated above, the component placement device 1 may be extended by adding additional modules 4. In this way a process characteristic, such as the number of different types of components that can be placed on a substrate upon passage through the component placement device 1, is enhanced. Furthermore this makes it possible to increase the handling capacity of the component placement device 1. In addition to that this makes it possible to place specific components, which are to be placed on the substrate with a relatively high degree of precision, on the substrate at a relatively slow rate, wherein the fact that said specific components are placed at a relatively slow rate does not lead to a slower rate of movement of the substrate 17 through the component placement device 1 on account of the fact that the placement of said specific components is carried out by several component pickup and placement units. As already indicated above, physically extending the device by increasing the number of modules 4 has this drawback, however, that substantial investments are required. When the component placement device 1 is to be extended at some point after its order, the component placement device 1 must be temporarily put out of surface, as a result of which no substrates can be provided with components. The component placement device 1 according to the invention preferably comprises the maximum number of modules 4 that is possible or the number of modules 4 that a user requires for realising the desired maximum handling capacity.

Upon purchase of the component placement device 1 according to the invention, a basic handling capacity is determined, being the handling capacity that is usually to be realised. Associated with said basic handling capacity are settings of the component placement device 1, such as the maximum allowable velocities at which the vacuum tube 15 can be moved in the directions indicated by the arrows X, Y, Z, the maximum allowable accelerations at which said movements can be carried out, the maximum allowable jerk, the minimum and maximum allowable waiting times and overlaps, the required safety margins, the maximum velocity at which the substrate 17 can be moved over the rails 16, the rate at which new components are presented at the component pickup positions 18, etc.

Said settings are input as standard settings into the control unit 11 of the component placement device 1. Different maximum allowable velocities, etc, may be input for different types of components. A number of standard settings may thus have been input for a particular process characteristic, such as the velocity, the acceleration, etc. The combination of all the standard settings is such, however, that maximally the basic handling capacity can be realised when using said settings. In case a higher handling capacity of the component placement device 1 is temporarily required, for example on account of an increased market demand, an electronic key is supplied to the component placement device 1 according to the invention, by means of which an optional setting of at least one process characteristic is temporarily enabled. Said optional setting may for example be a higher maximum allowable velocity, a higher allowable acceleration, etc. Said optional setting of settings make it possible to place more components 20 on substrate 17 within the same period of time, thereby increasing the handling capacity of the component placement device 1.

The electronic key may be an electronic code stored on a physical card in the form of a bar code, a numerical code, a magnetic code, an optical code, etc. Such a card can be physically fed to the component placement device 1 via a card reader 21 present in the control unit 11. It is also possible to supply the electronic key to the component placement device 1 from a remote computer via an electronic network.

Different types of electronic keys may be supplied to the component placement device 1. A first type of electronic key, for example, can only be used for increasing the maximum handling capacity that can be realised, whilst another type of electronic key can only be used for enhancing the placement precision to be realised. According to another possibility, a specific electronic key is associated with each individual component pickup and placement unit 5.

As already indicated above, in the embodiment of a component placement device 1 as shown herein a number of reels 8 are associated with each component pickup and placement unit 5. It is for example possible that according to the standard setting only half of said number of reels can be used. Supplying the electronic key enables the user to use more reels 8 and to supply components to the component pickup positions 18 from said reels 8.

It is also possible to fit the component pickup and placement units 5 with cameras, which can only be activated by means of the electronic key.

During the movement of the suction tube 15 holding a component 20 from the component pickup position 18 to the substrate 17, the maximum allowable accelerations and velocities are comparatively limited in order to ensure that the component 20 is precisely positioned on the substrate 17. The return movement of the suction tube 15 from the substrate 17 to the component pickup position 18 for picking up a new component 20 has practically no effect on the precision with which a component 20 is placed on a substrate 17, so that said maximum allowable accelerations and velocities may be relatively high in that case. Using the electronic key, the velocities and accelerations that can be realised by means of the optional setting can be increased in comparison with the standard settings in a simple manner. It is possible in this context to enhance the optional settings to different degrees by using different electronic keys.

Using the electronic key, the component placement device 1 will temporarily operate with the optional setting(s). After the expiry of the period of operation Δt associated with the electronic key, the standard setting of the component placement device 1 is reactivated. Different keys may have different periods of operation Δt.

Using various electronic keys it is possible, for example, to increase the optional setting in steps or to use the optional setting in question for a shorter or a longer period Δt.

A number of possibilities are shown by way of example in the table below.

| | 10% | 20% | 30% | 40% |
|---|---|---|---|---|
| 1xΔt | x1 | x2 | x3 | x4 |
| 2*Δt | x2 | x4 | x6 | x8 |
| 3*Δt | x3 | x6 | x9 | x12 |
| 4*Δt | x4 | x8 | x12 | x16 |

The electronic key x1 is used to activate, for a period of operation Δt of e.g. 1 week, an optional setting or optional settings by which the total handling capacity of the component placement device is increased by 10%. The electronic key x2 enables the user to realise either a 20% higher handling capacity for a period of operation Δt or a 10% higher handling capacity for a period of operation 2Δt. In either case the same capacity improvement will have been obtained after the expiry of the period of operation.

A user may purchase a number of electronic keys in dependence on the expected need for extension of the handling capacity. Usually, the costs for two electronic keys x6 will be higher than the costs for a single electronic key x12.

It is possible to terminate the operation of the electronic key before the expiry of the period of operation Δt of an electronic key, after which the standard settings are reactivated. In that case it is possible, if desired, to reactivate the electronic key for the remaining period of operation at a later point in time.

To that end a time registration will be added to the electronic key, in which the period of operation Δt is stored as well as the elapsed time during which use was made of the electronic key.

The period of operation may be bound by a maximum. According to another possibility, however, the period of operation is determined by a predetermined number of components placed on substrates while using the optional setting associated with the electronic keys.

It is also possible to reduce the maximum handling capacity by means of the electronic key, in which case the user might be given a discount on the purchase of other electronic keys, for example.

Using the method according to the invention, it is also possible to gear the simultaneous use of a number of component placements devices more optimally to each other, both within a production line and between production lines and between different production facilities factories at different locations.

## Claims

1. A method of adjusting at least one optional setting of a process characteristic of a component placement device provided with at least one component pickup and placement unit, **characterised in that** the component placement device has at least one standard setting, whilst the optional setting can be activated by means of an electronic key to be supplied to the component placement device, wherein said optional setting is temporarily activated by feeding the electronic key to the component placement device, whilst the standard setting is reactivated at least after the expiry of a predetermined period of operation of the electronic key.

2. A method according to claim 1, **characterised in that** a process characteristic comprises a number of optional settings, which can each be activated by means of an electronic key associated with a respective setting.

3. A method according to claim 1 or 2, **characterised in that** the setting can be activated by means of a number of different electronic keys, each of which keys have a different period of operation.

4. A method according to any one of the preceding claims, **characterised in that** the standard setting is reactivated if the electronic key is removed at a point in time prior to the expiry of the period of operation, in which case the electronic key can be activated anew for the remaining period of operation at a later point in time.

5. A method according to any one of the preceding claims, **characterised in that** the process characteristic comprises the handling capacity, i.e. the number of components to be placed by the component placement device per unit time.

6. A method according to claim 5, **characterised in that** the handling capacity is temporarily increased by means of the electronic key.

7. A method according to any one of the preceding claims, **characterised in that** the velocity at which a component is moved from a component pickup position to a component placement position is temporarily adapted by means of the electronic key.

8. A method according to any one of the preceding claims, **characterised in that** the velocity at which the component pickup and placement unit is moved from a component placement position to a component pickup position is temporarily adapted by means of the electronic key.

9. A method according to any one of the preceding claims, **characterised in that** the component placement device includes a plurality of component pickup positions, wherein the number of component pickup positions that are accessible to the component pickup and placement unit is temporarily adapted by means of the electronic key.

10. A method according to any one of the preceding claims, **characterised in that** the component placement device includes a plurality of component pickup and placement units, wherein the number of component pickup and placement units by means of which components can be picked up is temporarily adapted by means of the electronic key.

11. A method according to any one of the preceding claims, **characterised in that** the component placement device comprises a substrate supplying and discharging device, by means of which a substrate is moved to and from a position located near the component pickup and placement unit, wherein the transport velocity at which the substrate is moved is temporarily adapted by means of the electronic key.

12. A component placement device suitable for carrying out the method according to any one of the preceding claims, which component placement device comprises at least one component pickup and placement unit as well as means for adjusting at least one optional setting of a process characteristic of the component placement device, **characterised in that** the component placement device has at least one standard setting, means for supplying at least one electronic key to the component placement device, means for activating said optional setting temporarily on the basis of the electronic key, as well as means for activating the standard setting at least after the expiry of a predetermined period of operation of the electronic key.

13. An electronic key suitable for use with the method according to any one of the preceding claims 1-11 or with the component placement device according to claim 12, **characterised in that** the electronic key comprises a bar code, a numerical code, a magnetic code, an optical code, an RF code, a punch code, a chemical or a biological code.

14. An electronic key according to claim 13, **characterised in that** the electronic key is stored either on a card or electronically.

## Patentansprüche

1. Verfahren zum Einstellen von wenigstens einer fakultativen Einstellung eines Prozesskennwerts einer Bauelementbestückungsvorrichtung, die mit wenigstens einer Bauelementaufnahme- und -platziereinheit versehen ist, **dadurch gekennzeichnet, dass** die Bauelementbestückungsvorrichtung wenigstens eine Standardeinstellung hat, während die fakultative Einstellung mit Hilfe eines der Bauelementbestückungsvorrichtung zuzuführenden elektronischen Schlüssels aktiviert werden kann, wobei die fakultative Einstellung vorübergehend aktiviert wird durch Zuführen des elektronischen Schlüssels zu der Bauelementbestückungsvorrichtung, während die Standardeinstellung wenigstens nach dem Ablauf einer vorbestimmten Betriebszeitspanne des elektronischen Schlüssels reaktiviert wird.

2. Verfahren nach Anspruch 1, **dadurch gekennzeichnet, dass** ein Prozesskennwert eine Anzahl von fakultativen Einstellungen umfasst, von denen jede mit Hilfe eines elektronischen Schlüssels, welcher einer Einstellung zugeordnet ist, aktiviert werden kann.

3. Verfahren nach Anspruch 1 oder 2, **dadurch gekennzeichnet, dass** die Einstellung mit Hilfe einer Anzahl von unterschiedlichen elektronischen Schlüsseln aktiviert werden kann, wobei jeder Schlüssel eine andere Betriebszeitspanne hat.

4. Verfahren nach einem der vorhergehenden Ansprüche, **dadurch gekennzeichnet, dass** die Standardeinstellung reaktiviert wird, wenn der elektronische Schlüssel in einem Zeitpunkt vor dem Ablauf der Betriebszeitspanne entfernt wird, wobei in diesem Fall der elektronische Schlüssel für die verbleibende Betriebszeitspanne in einem späteren Zeitpunkt erneut aktiviert werden kann.

5. Verfahren nach einem der vorhergehenden Ansprüche, **dadurch gekennzeichnet, dass** der Prozesskennwert die Handhabungskapazität umfasst, das heißt die Anzahl der durch die Bauelementbestückungsvorrichtung pro Zeiteinheit zu platzierenden Bauelemente.

6. Verfahren nach Anspruch 5, **dadurch gekennzeichnet, dass** die Handhabungskapazität mit Hilfe des elektronischen Schlüssels vorübergehend erhöht wird.

7. Verfahren nach einem der vorhergehenden Ansprüche, **dadurch gekennzeichnet, dass** die Geschwindigkeit, mit der ein Bauelement aus einer Bauelementaufnahmeposition in eine Bauelementplatzierposition bewegt wird, mit Hilfe des elektronischen Schlüssels vorübergehend adaptiert wird.

8. Verfahren nach einem der vorhergehenden Ansprüche, **dadurch gekennzeichnet, dass** die Geschwindigkeit, mit der die Bauelementaufnahme- und -platziereinheit aus einer Bauelementplatzierposition in eine Bauelementaufnahmeposition bewegt wird, mit Hilfe des elektronischen Schlüssels vorübergehend adaptiert wird.

9. Verfahren nach einem der vorhergehenden Ansprüche, **dadurch gekennzeichnet, dass** die Bauelementbestückungsvorrichtung eine Vielzahl von Bauelementaufnahmepositionen aufweist, wobei die Zahl der Bauelementaufnahmepositionen, die für die Bauelementaufnahme- und -platziereinheit zugänglich sind, mit Hilfe des elektronischen Schlüssels vorübergehend adaptiert wird.

10. Verfahren nach einem der vorhergehenden Ansprüche, **dadurch gekennzeichnet, dass** die Bauelementbestückungsvorrichtung eine Vielzahl von Bauelementaufnahme- und -platziereinheiten aufweist, wobei die Zahl der Bauelementaufnahme- und -platziereinheiten, mit deren Hilfe Bauelemente aufgenommen werden können, mit Hilfe des elektronischen Schlüssels vorübergehend adaptiert wird.

11. Verfahren nach einem der vorhergehenden Ansprüche, **dadurch gekennzeichnet, dass** die Bauelementbestückungsvorrichtung eine Substratzuführ- und -abgabevorrichtung aufweist, mit deren Hilfe ein Substrat in eine und aus einer Position bewegt wird, welche sich nahe bei der Bauelementaufnahme- und -platziereinheit befindet, wobei die Transportgeschwindigkeit, mit der das Substrat bewegt wird, mit Hilfe des elektronischen Schlüssels vorübergehend adaptiert wird.

12. Bauelementbestückungsvorrichtung, die zum Ausführen des Verfahrens nach einem der vorhergehenden Ansprüche geeignet ist, wobei die Bauelementbestückungsvorrichtung wenigstens eine Bauelementaufnahme- und -platziereinheit sowie eine Einrichtung zum Einstellen von wenigstens einer fakultativen Einstellung eines Prozesskennwerts der Bauelementbestückungsvorrichtung aufweist, **dadurch gekennzeichnet, dass** die Bauelementbestückungsvorrichtung wenigstens eine Standardeinstellung hat, eine Einrichtung zum Zuführen von wenigstens einem elektronischen Schlüssel zu der Bauelementbestückungsvorrichtung, eine Einrichtung zum vorübergehenden Aktivieren der funktionalen Einstellung auf der Basis des elektronischen Schlüssels sowie eine Einrichtung zum Aktivieren der Standardeinstellung zumindest nach dem Ablauf einer vorbestimmten Betriebszeitspanne des elektronischen Schlüssels.

13. Elektronischer Schlüssel, geeignet zur Verwendung bei dem Verfahren nach einem der vorhergehenden Ansprüche 1 - 11 oder bei der Bauelementbestückungsvorrichtung nach Anspruch 12, **dadurch gekennzeichnet, dass** der elektronische Schlüssel einen Barcode aufweist, einen numerischen Code, einen magnetischen Code, einen optischen Code, einen RF-Code, einen Stanzcode, einen chemischen oder einen biologischen Code.

14. Elektronischer Schlüssel nach Anspruch 13, **dadurch gekennzeichnet, dass** der elektronische Schlüssel entweder auf einer Karte oder elektronisch gespeichert ist.

## Revendications

1. Procédé pour l'ajustement d'au moins une valeur facultative d'une caractéristique de procédé d'un dispositif de mise en place d'un composant avec au moins une unité de recueil et de positionnement du composant, **caractérisé en ce que** le dispositif de positionnement du composant présente au moins une valeur standard, tandis que la valeur facultative peut être activée au moyen d'une clé électronique fournie au dispositif de positionnement de composant, procédé dans lequel ladite valeur facultative est temporairement actionnée par l'alimentation de la clé électronique sur le dispositif de positionnement de composant, tandis que la valeur standard est réactivée au moins après l'expiration d'une durée prédéterminée de fonctionnement de la clé électronique.

2. Procédé selon la revendication 1, **caractérisé en ce qu'**une caractéristique de procédé comprend un certain nombre de valeurs facultatives qui peuvent chacune être activées au moyen d'une clé électronique associée à une valeur respective.

3. Procédé selon la revendication 1 ou la revendication 2, **caractérisé en ce que** la valeur peut être activée au moyen d'un certain nombre de différentes clés électroniques, dont chacune présente une durée de fonctionnement différente.

4. Procédé selon l'une quelconque des revendications précédentes, **caractérisé en ce que** la valeur standard est réactivée lorsque la clé électronique est enlevée à un moment précédant l'expiration de la durée de fonctionnement, auquel cas la clé électronique peut être activée à nouveau pour la période restante du fonctionnement à un moment ultérieur.

5. Procédé selon l'une quelconque des revendications précédentes, **caractérisé en ce que** la caractéristique du procédé comprend la capacité de manipulation, c'est-à-dire le nombre de composants à placer par le dispositif de positionnement de composant par temps unitaire.

6. Procédé selon la revendication 5, **caractérisé en ce que** la capacité de manipulation est provisoirement accrue grâce à la clé électronique.

7. Procédé selon l'une quelconque des revendications précédentes, **caractérisé en ce que** la vitesse à laquelle un composant est déplacé à partir d'une position de recueil de composant vers une position de mise en place du composant est provisoirement adaptée au moyen de la clé électronique.

8. Procédé selon l'une quelconque des revendications précédentes, **caractérisé en ce que** la vitesse à laquelle l'unité de recueil et de mise en place du composant est déplacée depuis une position de mise en place de composant vers une position de recueil de composant est provisoirement adaptée au moyen de la clé électronique.

9. Procédé selon l'une quelconque des revendications précédentes, **caractérisé en ce que** le dispositif de mise en place du composant comprend une pluralité de positions de recueil de composant, procédé dans lequel le nombre de positions de recueil de composant qui sont accessibles à l'unité de recueil et de mise en place de composant est provisoirement adapté au moyen de la clé électronique.

10. Procédé selon l'une quelconque des revendications précédentes, **caractérisé en ce que** le dispositif de positionnement de composant comprend une pluralité d'unités de recueil et de positionnement de composant, dans lequel le nombre d'unités de recueil et de positionnement de composant au moyen desquels les composants peuvent être prélevés est provisoirement adapté au moyen de la clé électronique.

11. Procédé selon l'une quelconque des revendications précédentes, **caractérisé en ce que** le dispositif de positionnement de composant comprend un dispositif de fourniture et de décharge de substrat, au moyen duquel un substrat est déplacé vers et à partir d'une position située à proximité de l'unité de recueil et de mise en place de composant, dans lequel la vitesse de transport à laquelle le substrat est déplacé est provisoirement adaptée au moyen de la clé électronique.

12. Dispositif de positionnement de composant apte à effectuer le procédé suivant l'une quelconque des revendications précédentes, lequel dispositif de positionnement de composant comprend au moins une unité de recueil et de positionnement de composant, ainsi que des moyens pour ajuster au moins une valeur facultative d'une caractéristique de procédé du dispositif de positionnement de composant, **caractérisé en ce que** le dispositif de positionnement de composant présente au moins une valeur standard, des moyens pour fournir au moins une clé électronique au dispositif de positionnement de composant, des moyens pour activer ladite valeur facultative provisoirement en fonction de la clé électronique, ainsi que des moyens pour activer la valeur standard au moins après l'expiration d'une durée prédéterminée de fonctionnement de la clé électronique.

13. Clé électronique convenant pour l'utilisation avec le procédé selon l'une quelconque des revendications précédentes 1-11 ou avec le dispositif de positionnement de composant selon la revendication 12, **caractérisée en ce que** la clé électronique comprend un code barres, un code numérique, un code magnétique, un code optique, un code RF, un code de perforation, un code chimique ou un code biologique.

14. Clé électronique selon la revendication 13, **caractérisée en ce que** la clé électronique est mémorisée soit sur une carte, soit électroniquement.
